# EUROPÄISCHE PATENTSCHRIFT

(11) **EP 1 088 241 B1**
(45) Veröffentlichungstag und Bekanntmachung des Hinweises auf die Patenterteilung: **03.07.2002**
(21) Anmeldenummer: 99957099.7
(22) Anmeldetag: 21.05.1999
(51) Int. Cl.: G01R 31/36, G01R 1/073

(54) **VORRICHTUNG ZUR SPANNUNGSMESSUNG**
VOLTAGE MEASURING DEVICE
DISPOSITIF DE MESURE DE TENSION

(30) Priorität: 18.06.1998 DE 19827045
(43) Veröffentlichungstag der Anmeldung: 04.04.2001
(73) Patentinhaber: Ballard Power Systems AG, 73230 Kirchheim / Teck-Nabern (DE)
(72) Erfinder: EINHART, Johann, D-88690 Uhldingen (DE); SONNTAG, Anton, D-89257 Ulm (DE); SONNTAG, Josef, D-73230 Kirchheim (DE)
(74) Vertreter: Kocher, Klaus-Peter Dipl.-Phys
(86) Internationale Anmeldenummer: EP9903493
(87) Internationale Veröffentlichungsnummer: WO9966339

(56) Entgegenhaltungen:
- WO-A-94/09374
- US-A- 3 818 325
- PATENT ABSTRACTS OF JAPAN vol. 96, no. 2, 29. Februar 1996 (1996-02-29) & JP 07 260825 A (NEC CORP), 13. Oktober 1995 (1995-10-13)

## Beschreibung

Die Erfindung betrifft eine Anordnung zur Spannungsmessung an mehr als zwei gleichartigen Spannungsquelleneinheiten gemäß dem Oberbegriff des unabhängigen Anspruchs.

Eine gattungsgemäße Spannungsquelleneinheit wird beispielsweise aus einer oder bevorzugt mehreren elementaren Batteriezellen oder auch von einer oder bevorzugt mehreren elementaren Brennstoffzellen gebildet.

Ein bevorzugtes Anwendungsgebiet einer derartigen Anordnung zur Spannungsmessung sind Brennstoffzellensysteme, insbesondere mit H₂/O₂-Brennstoffzellen, die üblicherweise eine Zellspannung von ca. 0,5 V bis 1,0 V liefern. Zur Erzielung höherer Spannungen und damit größerer Leistungen werden einzelne Brennstoffzellen zu einem Stapel seriell hintereinandergeschaltet. Es muß beim Betreiben der Brennstoffzellen sichergestellt sein, daß die Brennstoffzellen effektiv arbeiten und die vom Brennstoffzellenstapel gelieferte Leistung nicht einzelne Brennstoffzellen in unzulässige oder gefährliche Betriebszustände mit negativer Zellspannung zwingt, sondern daß sich die Zellspannungen in Abhängigkeit vom Lastzustand innerhalb einer gewissen Bandbreite halten. Weiterhin ist es wünschenswert, Defekte an der H₂/O₂-Separationseinheit feststellen zu können, die zu einem Ausfall einer Brennstoffzelle führen können.

In der DE-A1 43 38 178 ist eine Anordnung offenbart, bei der Brennstoffzellenstapel in wenigstens zwei parallel geschalteten Reihen mit jeweils gleicher Anzahl in den Reihen hintereinander geschaltet sind und bei der die Reihen in Zweige einer Brückenschaltung aufgeteilt und mit wenigstens einer Auswerteanordnung verbunden sind, die die zwischen den Zweigen abgegriffene Spannung oder den abgegriffenen Strom auswertet.

In der DE-C2 195 23 260 ist ein Verfahren zur Überwachung von mehr als zwei gleichartigen Spannungsquelleneinheiten offenbart, bei der Kontaktspitzen auf Kohlekollektoren von zu Blöcken zusammengefaßten Brennstoffzellenstapeln gedrückt werden. Die Kontaktierung der Stapel ist jedoch vibrationsanfällig und insbesondere nicht für den Einsatz in einem Kraftfahrzeug geeignet, da im wesentlichen nur eine stationäre Messung und keine Dauermessung unter Einsatzbedingungen möglich ist.

Die Aufgabe der Erfindung ist es, eine Anordnung zur Spannungsmessung an mehr als zwei gleichartigen Spannungsquelleneinheiten anzugeben, die einfach zu montieren ist, eine permanente Spannungsüberwachung und eine flexible Handhabung sowie eine einfache und preiswerte Anpassung an Brennstoffzellenstapel unterschiedlicher Größe ermöglicht und die insbesondere für den Einsatz in mobilen Systemen wie etwa Kraftfahrzeugen geeignet ist als auch in stationären Systemen.

Die Aufgabe wird durch die Merkmale des unabhängigen Anspruchs gelöst. Weiterführende und vorteilhafte Ausgestaltungen sind den weiteren Ansprüchen und der Beschreibung zu entnehmen.

Die erfindungsgemäße Vorrichtung zur Spannungsmessung an mehr als zwei gleichartigen Spannungsquelleneinheiten ist mit Kontaktierungsmitteln zum Spannungsabgriff und mit den Kontaktierungsmitteln verbundener Auswerteeinheit versehen, wobei zumindest mehrere Kontaktierungsmittel in einer Kontaktierungseinheit baulich zusammengefaßt sind.

Bevorzugt weist die Kontaktierungseinheit eine Halterung, elektrisch leitfähige Kontaktierungsmittel und elektrische Anschlußmittel, insbesondere Pfostensteckverbinder, für eine Auswerteeinheit oder für eine zwischen Auswerteeinheit und Kontaktierungseinheit zwischengeschaltete Zwischeneinheit auf.

Besonders bevorzugt weisen die Kontaktierungsmittel der Kontaktierungseinheit von zu kontaktierenden Spannungsquelleneinheiten lösbare elektrische Federkontakte auf.

In einer günstigen Anordnung ist die Kontaktierungseinheit als ebene Platte ausgebildet, auf der Federkontakte in etwa parallel zueinander und im wesentlichen senkrecht von der Längsachse der Platte abstehend angeordnet sind, wobei die Federkontakte jeweils an einem Ende fest mit der jeweils zugeordneten elektrischen Kontaktfläche elektrisch leitend verbunden und an ihrem freien Ende zumindest in Richtung der Längsachse bewegbar sind. Dabei ist besonders zweckmäßig, wenn die Kontaktierungsmittel zumindest bereichsweise eine korrosionsbeständige metallische Oberfläche aufweisen. Günstig ist, daß auf der Oberfläche der Spannungsquelleneinheiten Aufnahmeflächen für Kontaktierungsmittel zum Spannungsabgriff vorgesehen sind.

In einer bevorzugten Anordnung ist die Kontaktierungseinheit in Richtung ihrer Längsachse verschiebbar in einem Haltermodul angeordnet. Vorteilhaft ist, mehrere Kontaktierungseinheiten in Richtung ihrer Längsachse in einem Haltermodul nebeneinander anzuordnen, so daß die Kontaktierungsmittel kammartig nach außen weisen.

Zweckmäßigerweise ragen die Kontaktierungseinheit senkrecht in eine Führungsschiene eines Haltermoduls hinein, derart, daß die Kontaktierungseinheit entlang der Führungsschiene parallel zur Längsausdehnung eines Gehäuses oder zu einer Stapelrichtung der Spannungsquelleneinheiten verschiebbar ist.

Vorteilhafterweise ist die Auswerteeinheit in einem Gehäuse angeordnet. Günstigerweise ist die Auswerteeinheit ein zentrales Steuergerät. Erfindungsgemäß ist es vorgesehen daß die Auswerteeinheit eine Einheit zur Adressierung und/oder Aufbereitung von Meßdaten aufweist, und daß zwischen Kontaktierungseinheit und Auswerteeinheit eine Zwischeneinheit zur Adressierung und/oder Aufbereitung von Meßdaten zwischengeschaltet ist.

Eine besonders zweckmäßige Ausgestaltung ist, die Kontaktierungseinheit jeweils mit einer Flachbandleitung elektrisch mit der Auswerteeinheit oder einer zwischen Kontaktierungseinheit und Auswerteeinheit zwischengeschalteten Zwischeneinheit zumindest mittelbar zu verbinden.

Erfindungsgemäß ist jeder Kontaktierungseinheit ein Segment einer Zwischeneinheit geometrisch zugeordnet. Günstig ist, wenn die Zwischeneinheit zusätzlich zu Segmenten eine Grundeinheit aufweist, welche zumindest eine Datenbusschnittstelle und/oder eine Microcontrollerkarte aufweist. Vorteilhaft ist, daß die Zwischeneinheit zumindest Anschlußmittel für einen CAN-Bus aufweist.

Bevorzugt weist das Segment Multiplexereinheiten und dem Segment zugeordnete elektrische Verbindungsmittel auf, an welche Verbindungsmittel eine oder mehrere Kontaktierungseinheiten anschließbar sind.

In einer besonders bevorzugten Weiterbildung sind Kontaktierungseinheiten äquidistant entlang der Längsachse der Zwischeneinheit angeordnet. Bevorzugt sind elektrische Verbindungsmittel äquidistant entlang der Längsachse der Zwischeneinheit angeordnet. Weiterhin bevorzugt sind Bereiche von Mutliplexereinheiten äquidistant entlang der Längsachse der Zwischeneinheit angeordnet. Weiterhin bevorzugt sind Segmente mit Multiplexereinheiten und Verbindungsmitteln äquidistant entlang der Längsachse der Zwischeneinheit angeordnet.

Besonders bevorzugt ist die Längsausdehnung zumindest von Segmenten, Verbindungsmitteln und Kontaktierungseinheiten entlang der Längsachse der Zwischeneinheit gestaffelt, wobei die Längsausdehnung der Kontaktierungseinheiten eine erste Länge L1 ist, die Längsausdehnung der Bereiche von Multiplexereinheiten eine zweite Länge LM, die Längsausdehnung der Verbindungsmittel eine dritte Länge L4, die Längsausdehnung der Segmente eine vierte Länge L12 ist und wobei gilt, daß L1>L12>L4>LM.

Vorteilhafterweise ist die Längsausdehnung zumindest von Segmenten, Verbindungsmitteln und Kontaktierungseinheiten entlang der Längsachse der Zwischeneinheit gestaffelt und versetzt zur Stapelrichtung der Spannungsquelleneinheiten angeordnet, so daß beim Kürzen auf eine aktuelle Stapellänge der Spannungsquelleneinheiten die Funktion von Segmenten, Verbindungsmitteln und Kontaktierungseinheiten erhalten ist.

In einer günstigen Ausführung ist das Haltermodul am Gehäuse befestigbar. In einer weiteren günstigen Ausführung ist das Haltermodul an Spannungsquelleneinheiten befestigbar.

Zweckmäßig ist, Befestigungsmittel der Zwischeneinheit im Gehäuse mit Mitteln zur Kompensation von Längenänderungen der Zwischeneinheit und/oder des Gehäuses zu versehen.

In einer besonders vorteilhaften Ausgestaltung der Erfindung ist die Kontaktierungseinheit mit einem Entlademodul verbunden, welches eine niederohmige Überbrückung mindestens einer Spannungsquelleneinheit bildet. Damit ist es möglich, Einheiten der Spannungsquelleneinheiten einzeln oder zu mehreren in einem Stapel gezielt zu entladen und etwa zu Wartungszwecken gefahrlos zu entnehmen. Besonders vorteilhaft ist, wenn das Entlademodul mit Mitteln zum Anschluß einer elektronischen Datenverarbeitungseinrichtung versehen ist und insbesondere mit einer Software steuerbar ist.

Bevorzugt ist die Spannungsquelleneinheit eine Brennstoffzelle.

Besonders bevorzugt sind auf der Oberfläche der Brennstoffzelle Aufnahmeflächen für die Kontaktierungsmittel zum Spannungsabgriff vorgesehen. Damit ist die Kontaktierung mit Federkontakten besonders stabil und sicher, insbesondere gegen Stoß und/oder Vibrationen.

Der modulare Aufbau der erfindungsgemäßen Vorrichtung erlaubt eine sehr flexible und preiswerte Verwendung der Vorrichtung.

Im folgenden sind die Merkmale, soweit sie für die Erfindung wesentlich sind, eingehend erläutert und anhand von Figuren näher beschrieben. Es zeigen
- Fig. 1: eine Prinzipskizze einer Kontaktierungseinheit gemäß der Erfindung,
- Fig. 2: den Schnitt durch einen Kontaktbereich zwischen Spannungsquelleneinheiten und Kontaktierungsmitteln,
- Fig. 3: eine Kontaktierungseinheit in einem Haltemodul,
- Fig. 4: eine Prinzipskizze einer günstigen Anordnung der Kontaktierungseinheit,
- Fig. 5: eine Prinzipskizze einer vorteilhaften Anordnung der Spannungsmeßvorrichtung,
- Fig. 6: Details einer bevorzugten Zwischeneinheit,
- Fig. 7: eine bevorzugte geometrische Abstimmung der einzelnen Module, und
- Fig. 8: Details einer bevorzugten Anordnung von Kontaktierungsmitteln.

Im folgenden ist die Erfindung anhand von Brennstoffzellensystemen erläutert. Es versteht sich jedoch, daß die Anwendung der beschriebenen erfindungsgemäßen Vorrichtung nicht auf Brennstoffzellensysteme beschränkt ist, sondern auch für andere Spannungsquellensysteme in mobilen und stationären Systemen, wie mehrzellige Batteriesysteme und/oder Akkumulatoren und/oder Kondensatorbänke und/oder Vielkanalsysteme verwendbar ist. Besonders vorteilhaft ist die Anwendung in Fahrzeugen oder anderen Transportmitteln.

Ein Brennstoffzellenstapel, der elektrische Leistung insbesondere für Kraftfahrzeugtraktion bereitstellen soll, wird aus einer Vielzahl von hintereinandergeschalteten Brennstoffzellen gebildet, z.B. 100 bis 200 einzelnen Zellen.

Die erfindungsgemäße Vorrichtung erlaubt durch ihren modularen Aufbau eine sehr einfache und preiswerte Anpassung der Spannungsmeßvorrichtung an unterschiedliche Brennstoffzellenzahlen und durch die besondere mechanische Flexibilität der Kontaktierungsmittel auch an Brennstoffzellen mit unterschiedlichen Breiten, ohne für jede Stapelvariante eine neue Spannungsmeßvorrichtung entwerfen und anpassen zu müssen.

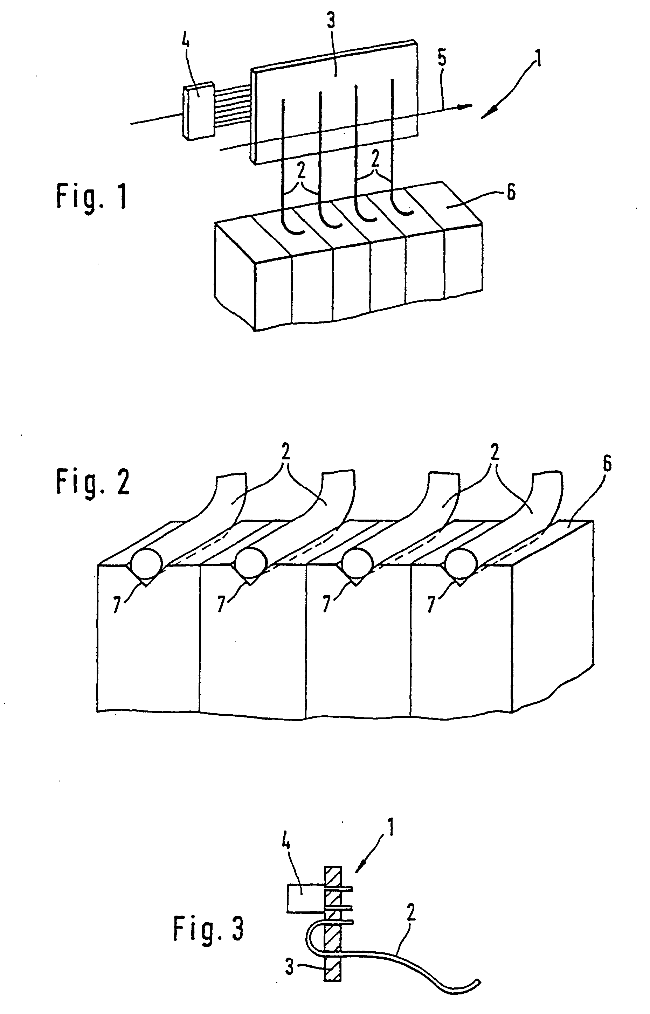

Eine beanspruchte Kontaktierungseinheit 1 ist in Fig. 1 abgebildet. Die Kontaktierungsmittel 2 sind erfindungsgemäß in der Kontaktierungseinheit 1 baulich zusammengefaßt. Vorzugsweise besteht eine Kontaktierungseinheit 1 aus Kontaktierungsmitteln 2, einer Halterung 3, insbesondere einer Platine mit Leiterbahnen, und einem Verbindungsmittel 4, an dem die Meßwerte abgegriffen werden können. Das Verbindungsmittel 4 ist vorzugsweise ein Stecker, an dem ein Anschlußkabel angeschlossen werden kann und der mit den Kontaktierungsmitteln 2 elektrisch verbunden ist.

Eine bevorzugte Kontaktierungseinheit 1 ist eine Microcontrollerkarte, vorzugsweise mit einer Vielzahl an der Kontaktierungseinheit 1 angebrachten, zum Spannungsabgriff an den Spannungsquelleneinheiten 6 vorgesehenen elektrischen Leitungen als Kontaktierungsmittel 2.

Eine besonders bevorzugte Kontaktierungseinheit 1 weist eine Mehrzahl von Federkontakten als Kontaktierungsmittel 2 auf, die auf der Kontaktierungseinheit zusammengefaßt sind. Günstig ist, mehrere Kontaktierungseinheiten 1 seriell angeordnet zur Spannungsmessung zu verwenden.

Federkontakte haben den Vorteil, daß zum einen eine zuverlässige elektrische Kontaktierung der Brennstoffzellen in einem Brennstoffzellenstapel möglich ist, zum anderen die Kontakte vom Brennstoffzellenstapel lösbar sind. Bei der Fertigung der Federkontakte ist es mit einfachen Mitteln möglich, insbesondere durch gezieltes Biegen und Überbiegen des Federdrahtes oder des Federblättchens, einen definierten Anpreßdruck der Federkontakte zu ermöglichen, so daß die Kontakte auch bei einer etwaigen Vibration der Anordnung einen sicheren elektrischen Kontakt zur Brennstoffzelle erlauben. Dies ist besonders für einen Einsatz der Spannungsmeßvorrichtung in einem Fahrzeug günstig, insbesondere ist damit eine permanente Überwachung von Brennstoffzellen auch im Betrieb möglich. Die bevorzugten Federkontakte sind preiswert, insbesondere in hohen Stückzahlen zu fertigen. Der Übergangswiderstand der Federkontakte zur Brennstoffzelle ist im wesentlichen von der Größe der Kontaktfläche und von der Auflagekraft abhängig. Die Federkraft wird erreicht, indem die Federdrähte bei der Fertigung um einen definierten Abstand überbogen werden. Bei der Anbringung der erfindungsgemäßen Vorrichtung auf einem Brennstoffzellenstapel kann die gewünschte Auflagekraft der Federkontakte eingestellt werden.

Ein weiterer Vorteil ist, daß der Schnittstellenaufwand zwischen Meßelektronik und Spannungsabgriff durch die Kontaktierungsmittel 2 gering ist, da lange Meßleitungen entfallen. Dadurch wird auch eine etwaige Störanfälligkeit durch elektromagnetische Einstrahlung auf Zellspannungsmeßgrößen verringert, so daß die EMV-Verträglichkeit der Vorrichtung für einen Einsatz in einem Kraftfahrzeug oder anderen, elektromagnetischer Einstrahlung ausgesetzten Einsatzorten sehr günstig ist. Eigene EMV-Messungen haben ergeben, daß die verwendete Vorrichtung die heutigen Anforderungen elektromagnetischer Verträglichkeit erfüllt.

Zweckmäßigerweise ist jeder Federkontakt, zumindest in dem zur Kontaktierung vorgesehenen Bereich, mit einem korrosionsbeständigen metallischen Überzug versehen. Vorzugsweise ist der Federkontakt vergoldet. Dabei ist es günstig, den korrosionsbeständigen Überzug erst nach dem Biegen der Federkontakte vorzunehmen, um etwaige Mikrorisse im Überzug durch Biegebeanspruchung zu vermeiden.

Die Federkontakte sind vorzugsweise so auf der Halterung 3 angeordnet, daß sie kammartig von der Halterung 3 abstehen. Dabei sind die Federkontakte senkrecht zu einer Längsachse 5 der Halterung 3 angeordnet und im wesentlichen parallel zueinander ausgerichtet. Besonders günstig ist es, als Halterung 3 eine Platinenkarte zu verwenden. Das vorgegebene Rastermaß der Leiterbahnen und/oder Kontaktierungspunkte läßt sich mit großem Vorteil nutzen, da es einen modularen Aufbau der Meßvorrichtung unterstützt.

Eine besonders günstige Anbringung der Federkontakte auf die Platinenkarte besteht darin, daß die Federkontakte aus einem Draht gefertigt werden, der zweimal um 90° abgewinkelt wird. Nach dem Abwinkeln weist der Federkontakt in etwa eine U-Form auf mit einem langen und einem kurzen Ende. Eine solche Feder ist z.B. in Fig. 3a dargestellt. Die beiden Enden stehen parallel zueinander, vorzugsweise ist der Abstand ein Mehrfaches des Platinenrasters der Kontaktierungseinheit 1. Bei einem üblichen Platinenraster von 2,54 mm ist ein zweifaches Rastermaß mit 5,08 mm als Abstand günstig.

Der Federkontakt wird mit beiden Enden bis zum Anschlag in Durchbrüche der Platinenkarte gesteckt und verlötet, womit eine hohe mechanische Stabilität gegen seitliches Verschieben der Federkontakte insbesondere beim Verlöten, erreicht wird. Günstigerweise stehen die Kontakte jetzt parallel, so daß sie wie ein Kontaktkamm an die Oberfläche eines Brennstoffzellenstapels gedrückt werden können, wobei zweckmäßigerweise je ein Federkontakt eine Brennstoffzelle eines Brennstoffzellenstapels kontaktiert.

Mit der Anordnung kann die Spannung entweder zwischen einem festen Bezugspunkt und Spannungsquelleneinheiten gemessen werden, oder es kann eine differentielle Spannungsmessung zwischen jeweils benachbarten Spannungsquelleneinheiten vorgenommen werden. Die differentielle Spannungsmessung hat den Vorteil, daß defekte Spannungsquelleneinheiten leicht zu lokalisieren sind.

Die Kontaktoberfläche zwischen Federkontakt und Brennstoffzelle entsteht, indem der Draht an der Spitze am freien Ende, welches zweckmäßigerweise das lange Ende ist, in einem Radius von wenigen Millimetern nach oben gebogen wird. Dieser Außenradius des Federdrahtes stellt zusammen mit zu kontaktierenden Brennstoffzellenoberfläche die Kontaktfläche dar. Günstig ist, als Aufnahmefläche eine in die Brennstoffzellenoberfläche gefräste Nut vorzusehen, welche den aufgedrückten Federkontakt gegen unerwünschtes seitliches Verschieben stabilisiert. Vorteilhaft ist, den Draht in einem größeren Abstand vom gekröpften freien Ende nochmals um einen Radius von wenigen Millimetern nach unten zu biegen. Die dabei eingestellte Auslenkung beeinflußt später bei der Anbringung der Kontaktierungseinheit 1 auf dem Brennstoffzellenstapel die gewünschte Anpreßkraft, eine nachträgliche und aufwendige Justage der Anpreßkraft entfällt. Dabei versteht sich, daß Biegeradius, Abstand für Biegung, Dicke und Länge der Federkontakte dem jeweiligen Meßproblem angepaßt werden können.

Das freie Ende der Federkontakte ist dabei nicht nur senkrecht zur Kontaktfläche des Brennstoffzellenstapels beweglich bzw. anpreßbar, sondern auch parallel dazu beweglich, insbesondere parallel zur Längsachse 5 der Platinenkarte 3. Dies hat den besonderen Vorteil, daß temperaturbedingte Dickenvariationen der Brennstoffzellen im Betrieb sicher ausgeglichen werden können, da die Federkontakte sich elastisch mit der Kontaktfläche 7 mitbewegen können. Zusätzlich ist auch die Justage der Federkontakte bezüglich der Kontaktflächen 7 der Brennstoffzellen vereinfacht und die Anforderungen an die Fertigungstoleranzen der Federkontakte sind verringert. Ein weiterer Vorteil ist, daß mit derselben Kontaktierungseinheit auch Brennstoffzellenstapel mit Brennstoffzellen unterschiedlicher Dicke kontaktiert werden können, ohne jeweils für geänderte Dicken eine neue Spannungsmeßvorrichtung entwerfen und fertigen zu müssen.

Durch die Elastizität der Federkontakte ist es auch möglich, daß eine Brennstoffzelle von mehr als einem Federkontakt kontaktiert wird, indem etwa zwei benachbarte Federkontakte in derselben Kontaktierungsnut angebracht werden. Damit ist der elektrische Kontakt besonders sicher und redundant ausgelegt, da bei etwaiger Beschädigung eines Kontaktes der zweite Kontakt funktionsfähig ist.

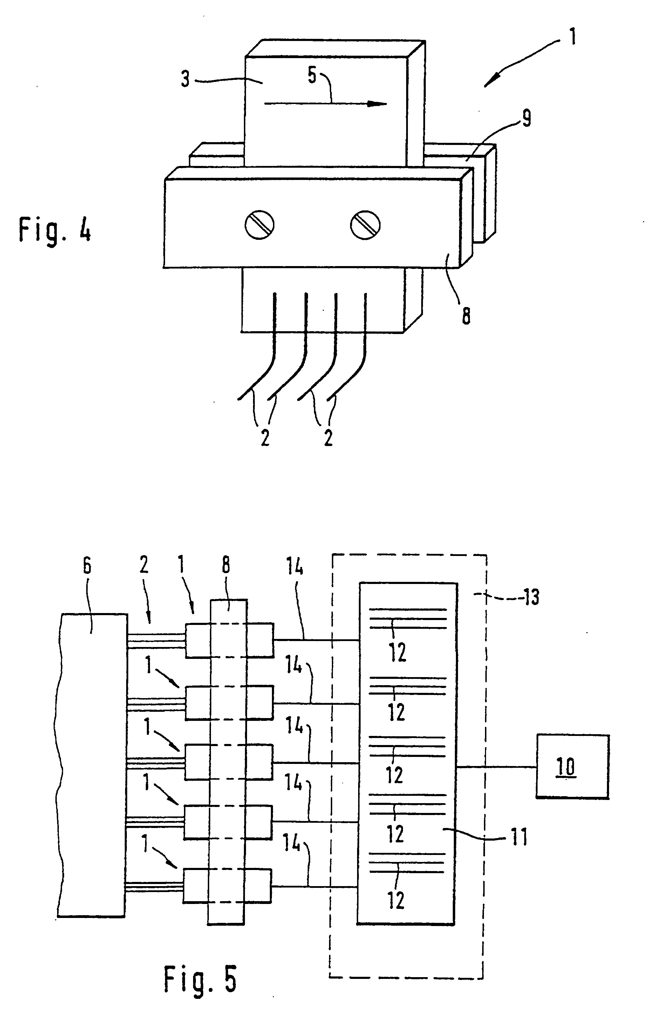

Eine günstige Anordnung ist in Fig. 4 dargestellt. Das Verbindungsmittel 4 ist nicht dargestellt. Die Halterung 3 ist in einer Befestigung so angeordnet, daß die Kontaktierungseinheit 1 längs der Längsachse 5, die vorzugsweise parallel zur Stapelrichtung der Spannungsquelleneinheiten verläuft, verschoben werden kann. Besonders bevorzugt wird die Platinenkarte 3 in senkrechter Einbaulage in Längsführungen 9 in einem Haltermodul 8 fixiert. In dem Haltermodul 8 kann die Kontaktierungseinheit 1 verschoben werden, so daß die Kontaktierungsmitte] 2 leicht über die Kontaktflächen 7 auf den Brennstoffzellenstapeln zu bringen sind.

Besonders günstig ist, wenn die Kontaktierungseinheit 1 nur wenige Kontaktierungsmittel 2 aufweist, z.B. 1-10 Kontaktierungsmittel. Damit läßt sich vorteilhaft eine etwaige Varianz von Zellbreiten der Brennstoffzellen ausgleichen, welche insbesondere durch Fertigungstoleranzen und/oder Wärmeausdehnung verursacht werden kann. Um die Spannung von einem Stapel mit Spannungsquelleneinheiten abgreifen zu können, werden mehrere, vorzugsweise gleichartige Kontaktierungseinheiten 1 verwendet, die nebeneinander in die Längsführung 9 der Haltermodul 8 gesteckt werden. Es werden bevorzugt so viele Kontaktierungseinheiten 1 nebeneinander angeordnet wie notwendig sind, um eine gewünschte Zahl an Spannungsquelleneinheiten 6 in einem Stapel von Spannungsquelleneinheiten elektrisch zu kontaktieren. Eine bevorzugte Ausführung ist, jede einzelne Spannungsquelleneinheit 6 mit jeweils einem Kontaktierungsmittel 2 zu versehen. Eine weitere bevorzugte Ausführung ist, eine Mehrzahl von Spannungsquelleneinheiten 6 als Block zusammenzufassen und für jeden Block ein Kontaktierungsmittel 2 vorzusehen.

Die Kontaktierungseinheiten 1 können in der Längsführung 9 verschoben und bezüglich der Spannungsquelleneinheiten 6 justiert und anschließend im Haltermodul 8 fixiert werden. Besonders günstig ist die Verwendung von Kunststoffhaltern als Haltermodul 8. Durch die Verwendung von Kunststoffhaltern ist eine Spannungsfestigkeit der Anordnung gewährleistet, so daß auch höhere Spannungen, insbesondere um 1000 VDC, mit ausreichenden Luft- und Kriechstrecken der Vorrichtung gemessen werden können. Insbesondere sind für Kraftfahrzeuge gültige Normen hinsichtlich derartiger Anforderungen an Spannungsfestigkeiten leicht einzuhalten.

Die Kontaktierungseinheit 1 ist zumindest mittelbar mit einer Auswerteeinheit 10 verbunden. Dies ist in Fig. 5 dargestellt. Diese ist bevorzugt ein zentrales Steuergerät, welches vorzugsweise elektronische Datenverarbeitungsmittel aufweist und welches die Spannungsmeßwerte, die von den Kontaktierungsmitteln 2 der Kontaktierungseinheit 1 über den Spannungsquelleneinheiten 6 abgegriffen werden, auswerten und weiterverarbeiten kann. Günstig ist, wenn die Auswerteeinheit 10 eine Einheit zur Adressierung und/oder Aufbereitung von Meßdaten aufweist. Vorzugsweise weist die Auswerteeinheit Verbindungen mit einem Datenbus, insbesondere CAN-Bus auf. Der modulare Aufbau der Kontaktierungseinheiten 1 ermöglicht eine Auswertung von Meßdaten durch beliebige elektronische Geräte.

Eine besonders bevorzugte Anordnung ist, wenn zwischen Auswerteeinheit 10 und Kontaktierungseinheit 1 eine Zwischeneinheit 11 geschaltet ist, welche zumindest zur Adressierung von Kontaktierungsmitteln 2 und/oder Kontaktierungseinheiten 1 und/oder Auswertung von Meßdaten vorgesehen ist. Die elektrische Verbindung zwischen Kontaktierungseinheit 1 und Auswerteeinheit 10 oder Zwischeneinheit 11 erfolgt bevorzugt über eine Flachbandleitung 14 zwischen dem Verbindungselement 4 der Kontaktierungseinheit 1 und der jeweils angeschlossenen Einheit 11 oder 10. Die Verbindung zwischen Zwischeneinheit 11 und Auswerteeinheit 10 erfolgt vorzugsweise über einen Datenbus. Zusätzlich können die von der erfindungsgemäßen Spannungsmeßvorrichtung aufgenommenen Spannungsmeßdaten mit weiteren Meßgrößen, insbesondere Analogwerte wie Temperaturwerte von Brennstoffzellen, Kühlwassertemperaturen von Brennstoffzellen, Gaszusammensetzung, und/oder Informationen über die Integrität des Datenbusses, Informationen über die Integrität des elektrischen Kontaktes zu Spannungsquelleneinheiten 6 und anderen für den Betrieb eines Brennstoffzellensystems relevanten Daten und/oder Fehler- und Alarmsignalen vorzugsweise in einer elektronischen Datenverarbeitungsanlage weiterverarbeitet werden.

Eine günstige Methode der Spannungsmessung besteht dabei darin, daß die Spannungsdifferenz zwischen zwei benachbarten Spannungsquelleneinheiten erfaßt wird.

Besonders bevorzugt ist die Zwischeneinheit 11 eine Microcontrollerkarte, die in Segmente 12 unterteilt ist. Besonders günstig ist, jeder Kontaktierungseinheit 1 ein Segment 12 der Microcontrollerkarte zuzuordnen. Dabei ist es zweckmäßig, Segmente 12 und Kontaktierungseinheiten 1 geometrisch auf ein einheitliches Rastermaß zu beziehen. Vorteilhaft ist, zumindest eine Anbindung an einen Datenbus, insbesondere einen CAN-Bus, vorzusehen. Die Microcontrollerkarte ist bevorzugt so ausgelegt, daß ausreichende elektrische Kriechstrecken und Luftstrecken zur Messung höherer Spannungen, vorzugsweise um 1000 VDC, insbesondere in einem Brennstoffzellenfahrzeug, eingehalten sind.

Die Zwischeneinheit 11 ist vorzugsweise in einem Gehäuse 13, welches vorzugsweise aus einem Deckelteil und einem Bodenteil gebildet ist, angeordnet. Vorzugsweise sind Mittel im Gehäuse 13 vorgesehen, um die Zwischeneinheit 11 aufzunehmen, wobei eine Verschiebung der Zwischeneinheit 11 innerhalb des Gehäuses 13 ermöglicht ist. Günstig ist, als Gehäuse 13 ein Standard-Strangpreßprofil aus Aluminium zu verwenden, welches als preiswerte Meterware erhältlich ist und in seinen Abmessungen leicht auf die Microcontrollerkarte zugeschnitten werden kann. Das Gehäuse 13 ist an Verbindungsstellen und etwaigen Durchführungen vorzugsweise zumindest spritzwassergeschützt ausgeführt, so daß die Microcontrollerkarte bei Betrieb der Vorrichtung insbesondere in einem Fahrzeug gegen Witterungseinflüsse von allen Seiten zuverlässig geschützt ist.

Zweckmäßigerweise sind am Gehäuse 13 Mittel vorgesehen, um Kontaktierungseinheiten 1 und/oder Haltermodul 8 am Gehäuse 13 zumindest mechanisch zu befestigen. Günstig ist, die Mittel mit Justiermöglichkeiten zu versehen, um ein Verschieben der Einheiten und/oder eine nachträgliche Anpassung an temperaturbedingte Längenänderungen der Einheiten zu ermöglichen.

In einer bevorzugten Ausführung ist eine Zwischeneinheit 11 für eine maximale Anzahl Nₘₐₓ von Spannungsquelleneinheiten 6 und/oder Kontaktierungseinheiten 1 und/oder Kontaktierungsmittel 2 ausgelegt, so daß ausgehend von derselben Zwischeneinheit 11 Stapelvarianten von einer bis zu Nₘₐₓ Spannungsquelleneinheiten 6 gemessen werden können. Microcontrollerkarte und/oder Gehäuse 13 können passend zur Zahl der Spannungsquelleneinheiten 6 in einem Stapel gekürzt werden.

In einer bevorzugten Ausführung können Spannungen von bis Nₘₐₓ =200 Brennstoffzellen in einem Stapel im Bereich von wenigen Millisekunden pro Kanal, bevorzugt 1 Millisekunde pro kanal, erfaßt werden. Zweckmäßigerweise ist die Auswerteeinheit 10 und etwaige für die Auswerteeinheit vorgesehene Software ebenso für dieselbe maximale Zahl Nₘₐₓ ausgelegt, so daß die aktuelle Anzahl von Spannungsmessungen auf einfache Weise durch die Software konfigurierbar ist. Vorzugsweise ist die Länge der Microcontrollerkarte zumindest proportional der Zahl der Kontaktierungseinheiten 1, welche in der erfindungsgemäßen Vorrichtung baulich zusammengefaßt sind. Besonders bevorzugt sind die Längen der Microcontrollerkarte, des Gehäuses 13 und die Gesamtlänge der vorhandenen Kontaktierungseinheiten 1 in etwa gleich und entsprechen zweckmäßigerweise der Länge des Stapels der Spannungsquelleneinheiten 6. Damit ist es möglich, die Vorrichtung direkt, ggf. elektrisch isoliert, über den Spannungsquelleneinheiten 6 zu montieren werden.

In einer bevorzugten Anordnung sind Kontaktierungseinheiten 1 zumindest mechanisch fest mit dem Gehäuse 13 verbunden, so daß Kontaktierungseinheiten 1 und Gehäuse 13 mit Zwischeneinheit 11 im Dauerbetrieb benachbart zu den Spannungsquelleneinheiten 6 angeordnet sind. Die Auswerteeinheit 10 kann entfernt davon angeordnet sein. Es ist auch möglich, Gehäuse 13 mit Zwischeneinheit 11 und/oder Auswerteeinheit 10 in größerer Entfernung von den Spannungsquelleneinheiten 6 anzuordnen. Günstig ist, diese mittels Flachbandleitungen zu verbinden. Die Spannungsquelleneinheiten 6 können permanent während des Betriebs überwacht werden.

Besonders vorteilhaft ist es, ein Entlademodul für individuelle Spannungsquelleneinheiten 6 oder Blöcke von Spannungsquelleneinheiten 6 vorzusehen, welches in der Zwischeneinheit 11 oder in der Auswerteeinheit 10 integriert ist. Das Entlademodul ist insbesondere softwarekonfigurierbar und ansteuerbar, so daß es im Fehlerfall etwaige gestörte Spannungsquelleneinheiten auf von der Auswerteeinheit 10 vorgegebene und/oder überwachte unkritische Spannungswerte entlädt. Vorzugsweise wird der Spannungszustand einer Zelle oder eines überwachten Zellenstapels erst gemessen und diese dann entladen. Für den Anwender sind etwaige gestörte Spannungsquelleneinheiten 6 dann gefahrlos für Wartungszwecke zugänglich.

In einer weiteren bevorzugten Anordnung werden Kontaktierungseinheiten 1 zumindest mechanisch fest auf den Spannungsquelleneinheiten 6 montiert. Dies ist bei hoher Betriebs- oder Umgebungstemperatur der Spannungsquelleneinheiten 6 günstig. Die Zwischeneinheit 11 und Auswerteeinheit 10 können entfernt bei für diese zulässigen Umgebungstemperaturen untergebracht sein. Der Anschluß an die Kontaktierungseinheit 1 kann dann bedarfsweise, insbesondere in Wartungsintervallen, erfolgen, indem Verbindungsmittel 4 mit der Zwischeneinheit 11 oder der Auswerteeinheit 10 elektrisch verbunden wird. Die Möglichkeit einer dezentralen Montage der Module Auswerteeinheit 10, Zwischeneinheit 11 mit den Segmenten 12 im Gehäuse 13 und Verbindungsleitungen vom Verbindungsmittel 4 zur Kontaktierungseinheit 1 ist besonders günstig bei Platzproblemen oder Montageproblemen an den Spannungsquelleneinheiten.

Ein weiterer Vorteil liegt darin, daß die Spannungsmeßeinrichtung bei einer Montage der Kontaktierungseinheit 1 direkt auf dem Stapel der Spannungsquelleneinheiten 6 nur einen sehr geringen Einbauraum benötigt. Ein geringer Platzbedarf ist besonders bei einem Einbau in ein Fahrzeug mit Brennstoffzellen günstig. So ist es auch möglich, die Spannungsüberwachung und Zustandskontrolle der Brennstoffzellen nur intervallweise bei einem Wartungsvorgang und/oder einer Diagnose des Fahrzeugs vorzunehmen, so daß etwa teure Auswerteelektronik nicht in jedes Fahrzeug eingebaut werden muß, sondern nur stationär in entsprechenden Wartungseinrichtungen verfügbar sein muß. Für verschiedenste Anwendungsfälle ist dann dort eine einzige Auswerteelektronik ausreichend. In einer besonders vorteilhaften Ausgestaltung ist die Microcontrollerkarte 11 so ausgelegt, daß Informationen über Zahl der Spannungsquelleneinheiten 6 und Art der Verschaltung der Spannungsquelleneinheiten 6 im Microcontroller abgelegt ist. Die abgelegte Information ist vorteilhaft von außen am Fahrzeug abfragbar, bevorzugt mittels eines Steckers zur Durchführung eines Bus-Scans. Damit kann bei unterschiedlichen Varianten der Spannungsquellenstapel, z.B. in verschiedenen Fahrzeugvarianten, Zahl der Spannungsquelleneinheiten 6 und Art der Verschaltung der Spannungsquelleneinheiten 6 von außen erkannt werden, ohne das System öffnen zu müssen. Dies ist besonders wartungsfreundlich.

Damit ist es möglich, für unterschiedliche Stapelvarianten von Spannungsquelleneinheiten ein einheitliches Meßsystem und eine einheitliche Software zu verwenden. Es gelingt vorteilhaft, ausgehend von einem einheitlichen geometrischen Design und einer einheitlichen Auslegung für die Adressierung und/oder Ansteuerung der Meßvorrichtung eine Vorrichtung für eine Bandbreite von Stapeln von Spannungsquelleneinheiten 6 mit unterschiedlicher Anzahl von Spannungsquelleneinheiten 6 und/oder verschiedenen Dicken von Spannungsquelleneinheiten 6 verfügbar zu machen.

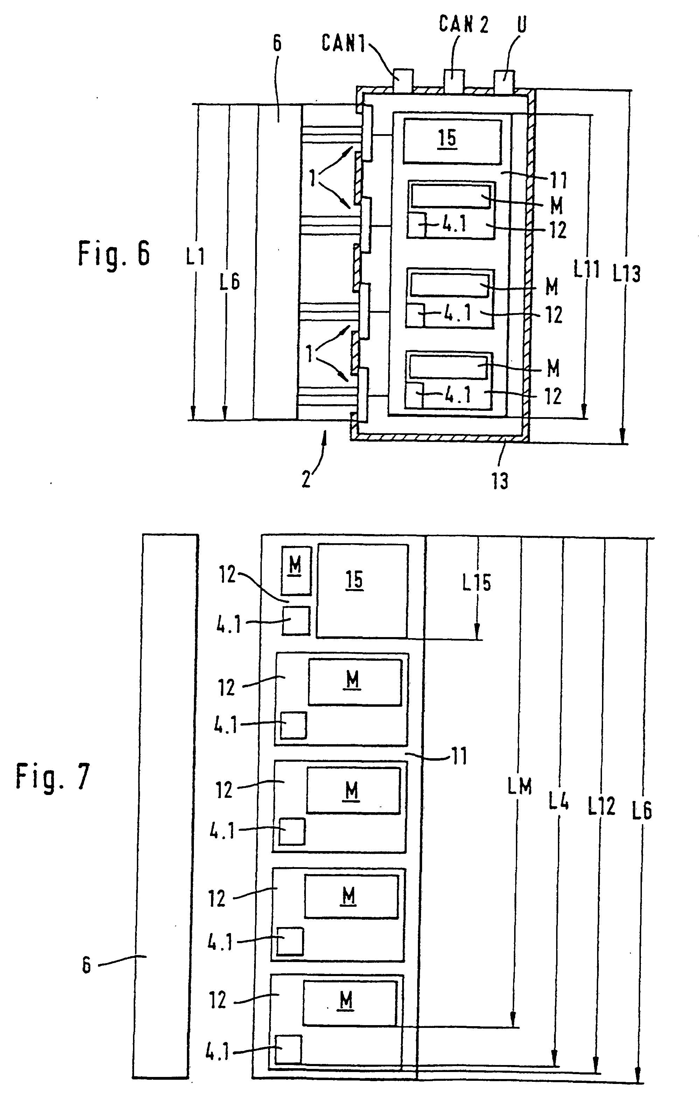

In Fig. 6 ist eine besonders bevorzugte Ausführung der modularen Spannungsmeßvorrichtung als Prinzipschaubild dargestellt. Ein Gehäuse 13 umhüllt eine Primärkarte als Zwischeneinheit 11, die eine Grundeinheit 15 aufweist, welche mit Datenbusanschlußmitteln auf einer Schnittstellenkarte und mit Elementen zur elektronischen Ansteuerung auf einer Microcontrollerkarte versehen ist.

Die Größe der Grundeinheit 15 legt eine Mindestgröße L11 der Primärkarte 11 fest. Die Grundeinheit 15 ist an einem Ende der Primärkarte angeordnet. Anschließend an die Grundeinheit 15 sind Multiplexereinheiten M mit jeweils zugeordneten Verbindungsmitteln 4.1 in Segmenten 12 längs der Längsachse der Primärkarte montiert. Die Längsachse der Primärkarte ist parallel zu der Stapelrichtung der Spannungsquelleneinheiten 6. Bevorzugt sind die Verbindungsmittel 4.1 Pfostenstecker, die auf der Primärkarte 11 fest montiert sind. An den Pfostensteckern 4.1 können elektrische Leitungen 14 von einer oder mehreren Kontaktierungseinheiten 1 eingesteckt sein. Vorzugsweise sind die elektrischen Leitungen 14 Flachbandleitungen. Jedes angeschlossenen Kontaktierungsmittel 2 kann als Meßkanal aufgefaßt werden. Die Meßgenauigkeit der bevorzugten Vorrichtung liegt bei etwa ± 5mV pro Kanal, die Meßgeschwindigkeit liegt bei etwa 1 msec pro Kanal.

Am Gehäuse 13 sind Verbindungsmittel für mindestens einen CAN-Bus und eine Spannungsversorgung U für die Primärkarte vorgesehen. Insbesondere ist der Betrieb der Primärkarte 11 mit Spannungen zwischen 7 und 36 Volt möglich. Es ist weiterhin möglich, die elektrische Versorgung der Primärkarte durch die kontaktierten Spannungsquelleneinheiten 6 selbst vorzunehmen, wozu vorteilhaft die Multiplexereinheiten M verwendet werden können, so daß die Spannungsquelleneinheiten 6 nicht asymmetrisch belastet werden. Die Kontaktierungsmittel 2 werden dabei im Takt von Millisekunden pro Kontaktierungsmittel angesprochen und umgeschaltet. Vorzugsweise sind zwei Anschlußmöglichkeiten CAN1, CAN2 für CAN-Bus möglich, so daß neben einer Verbindung zu einer Ansteuereinheit 10 über einen ersten CAN-Bus CAN1 auch eine visuelle Darstellung der Meßdaten insbesondere auf einem tragbaren Datenverarbeitungsgerät möglich ist, welches über einen zweiten CAN-Bus CAN2 oder anderen Datenbus angeschlossen sein kann.

Die einzelnen Einheiten sind günstigerweise auf ein einheitliches Rastermaß derart abgestimmt, daß die einzelnen Module in ihrer Ausdehnung längs der Längsachse der Primärkarte gestaffelt sind. Als Nullpunkt wird jenes Ende der Primärkarte 11 bezeichnet, an dem die Grundeinheit 15 angebracht ist. Die größte Länge L1 weist einer Reihe von nebeneinander angeordneten Kontaktierungseinheiten 1 auf, wobei L1 so groß ist wie die Stapellänge L6 der Spannungsquelleneinheiten 6. Das Gehäuse 13 weist eine Länge L13 auf, die es ermöglicht, eine Reihe von in Richtung ihrer Längsachse 5 nebeneinander angeordneten Kontaktierungseinheiten 1 mit der Länge L1 vollständig aufzunehmen. Die Primärkarte 11 weist eine Länge L11 auf, die kürzer als L1 ist. Segmente 12 mit Multiplexereinheiten M und zugeordneten Verbindungsmitteln 4.1 sind in etwa äquidistant in Richtung der Längsachse der Primärkarte angeordnet, wobei die maximale Länge L12 ist. Die Pfostenstecker 4.1 sind in etwa äquidistant auf einer Achse mit einer Länge L4 parallel zur Längsachse der Primärkarte angeordnet, wobei die Länge L4 kleiner ist als L11. Vorzugsweise sind die Pfostenstecker 4.1 jeweils ausgehend vom Nullpunkt innerhalb jeweils eines Segments 12 oberhalb der zugeordneten Multiplexereinheit M angebracht, so daß ein Pfostenstecker 4.1 jeweils den geometrischen Abschluß eines Segments 12 bildet. Die Länge LM der Reihe der Multiplexereinheiten M ist kleiner als die Länge L4 der Reihe der Pfostenstecker 4.1.

Die minimale Größe L15 der Primärkarte 11 ist durch die Ausdehnung der Grundeinheit 15 in Längsrichtung der Primärkarte vorgegeben. Zweckmäßigerweise entspricht jedem Segment 12 eine gleiche Anzahl von Kontaktierungseinheiten 1 und/oder Kontaktierungsmitteln 2 und/oder Spannungsquelleneinheiten 6. Jedes Längeninkrement der Primärkarte 11 entspricht demnach einer im wesentlichen konstanten Anzahl von Kontaktierungseinheiten 1 und/oder Kontaktierungsmitteln 2 und/oder Spannungsquelleneinheiten 6. Bevorzugt ist neben der Grundeinheit 15 auf gleicher Höhe ein Segment 12 angeordnet. Demnach entspricht der minimalen Länge L15 der Primärkarte 11 eine minimale Anzahl von Spannungsquelleneinheiten 6, auf die die erfindungsgemäße Vorrichtung angewendet werden kann. Die Staffelung der Längen der einzelnen Einheiten ist in Fig. 7 schematisch dargestellt.

Eine bevorzugte Vorrichtung ist für 196 Spannungsquelleneinheiten ausgelegt. Die minimale Größe der Anordnung ist durch die Länge L15 der Grundeinheit 15 gegeben. Die Größe der Grundeinheit 15 entspricht einer Stapelhöhe von 70 Spannungsquelleneinheiten. Demnach können mit der bevorzugten Vorrichtung beliebige Stapelgrößen zwischen 70 und 196 Spannungsquelleneinheiten 6 kontaktiert werden, indem diese direkt auf den Spannungsquellenstapel montiert werden. Die einzelnen Einheiten der Vorrichtung müssen lediglich auf die der Anzahl der zu messenden Spannungsquelleneinheiten 6 gekürzt werden. Dabei ist durch die Staffelung der Längen der einzelnen Einheiten sichergestellt, daß beim Kürzen der Primärkarte 11 immer nur ein nicht benötigter Teil der Primärkarte abgeschnitten wird. Wird jeweils zwischen zwei Segmenten 12 gekürzt, ist sichergestellt, daß keine aktiven Bereiche der Primärkarte getrennt werden so daß die Funktion der restlichen Einheiten ungestört erhalten bleibt. Eine Verletzung von elektrischen Zuleitungen und Signalbahnen in dem Teil der Primärkarte, der in die Vorrichtung eingebaut wird, ist durch die geometrische Zuordnung der Segmente 12 auf der Primärkarte 11 zu den Kontaktierungseinheiten 1 und/oder Spannungsquelleneinheiten 6 zuverlässig ausgeschlossen, ohne daß für unterschiedliche Stapellängen ein aufwendiges Redesign der Vorrichtung notwendig wäre. Bei weniger als 70 Spannungsquelleneinheiten 6 kann die Primärkarte 11 entweder entfernt vom Stapel angeordnet werden oder die Primärkarte 11 überragt den Stapel, wobei überzählige Kontaktierungseinheiten 1 und/oder Kontaktierungsmittel 2 nicht benutzt werden.

Die Grundeinheit 15 ist sehr flach ausgebildet, wobei die Höhe des Gehäuses 13 höchstens 25 mm beträgt, so daß die Vorrichtung auch in Bereichen montiert werden kann, wo wenig Platz zur Verfügung steht. Trotz der geringen Bauhöhe ist keine Fremdkühlung notwendig, da die Kühlung über die Gehäusefläche ausreichend ist.

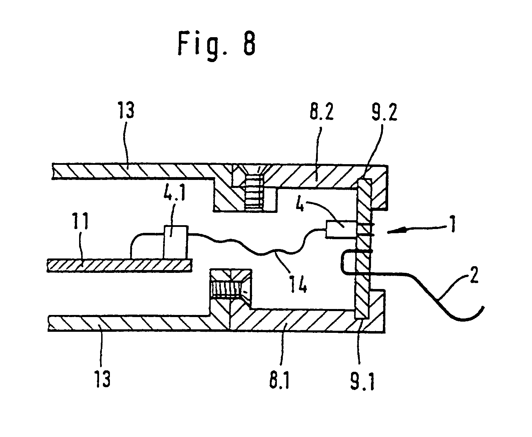

In Fig. 8 ist ein seitlicher Schnitt durch eine bevorzugte Vorrichtung gezeigt, der Details der Verbindung zwischen Haltemodul 8 und Gehäuse 13 darstellt. Die Primärkarte 11 und die Pfostenstecker 4.1 sind innerhalb des Gehäuses 13 angebracht. Vom Pfostenstecker 4.1 aus führt eine Flachbandleitung als flexible elektrische Verbindungsleitung 14 zu einer Kontaktierungseinheit 1. Im Durchführungsbereich zur Kontaktierungseinheit 1 kann insbesondere eine Gummidichtung vorgesehen sein, um das Gehäuseinnere gegen Nässe und Schmutz zu schützen. In den Kontaktierungseinheiten 1 zugewandten Seitenfläche des Gehäuses 13 sind vorzugsweise in den Bereichen der Pfostenstecker 4.1 als Durchführung der elektrischen Zuleitungen Aussparungen vorgesehen. Das Haltemodul 8 ist in ein unteres Teil 8.1 und ein oberes Teil 8.2 unterteilt. Beide können mit Schrauben lösbar mit dem Gehäuse 13 verbunden sein. Das untere Haltemodulteil 8.1 wird an das Gehäuseunterteil geschraubt und die Kontaktierungseinheit 1 in eine Nut 9.1 des Teils 8.1 senkrecht eingebaut. Das obere Teil 8.2 des Haltemoduls 8 weist ebenfalls eine Nut 9.2 auf, und das Teil wird so auf die Kontaktierungseinheit aufgesetzt, daß die Kontaktierungseinheit 1 innerhalb der Nut verschiebbar ist. In diesem Zustand kann die Kontaktierungseinheit 1 mit den Kontaktierungsmitteln 2 bezüglich der Spannungsquelleneinheiten 6 justiert werden. Um die Kontaktierungseinheiten 1 zu fixieren, wird das obere Teil 8.2 von oben auf das Gehäuse aufgeschraubt, so daß der Druck des Teils die Kontaktierungseinheit 1 fixiert. Eine vorteilhafte geringe Höhe des Gehäuses 13 wird erreicht, wenn das obere Gehäuseteil für die Aufnahme des oberen Teils 8.2 des Haltemoduls einen Vorsprung mit entsprechenden Schraubenlöchern aufweist.

Die Vorrichtung ist nicht nur zum Abgriff von Spannungen geeignet, es können auch andere Analogsignale aufgenommen oder eingespeist werden und insbesondere mittels der Zwischeneinheit 11 einer Auswertung und/oder Weiterverarbeitung zugeführt werden.

## Patentansprüche

1. Vorrichtung zur Spannungsmessung an mehr als zwei gleichartigen Spannungsquelleneinheiten (6) mit Kontaktierungsmitteln (2) zum Spannungsabgriff und mit den Kontaktierungsmitteln verbundener Auswerteeinheit (10), wobei zumindest mehrere Kontaktierungsmittel (2) in einer Kontaktierungseinheit (1) baulich zusammengefaßt sind,
**dadurch gekennzeichnet,**
**daß** mehrere Kontaktierungseinheiten (1) in Richtung ihrer Längsachse (5) in einem Haltermodul (8) nebeneinander angeordnet sind,
**daß** zwischen Kontaktierungseinheit (1) und Auswerteeinheit (10) eine Zwischeneinheit (11) zur Adressierung und/oder Aufbereitung von Meßdaten zwischengeschaltet ist und
**daß** jeder Kontaktierungseinheit (1) ein Segment (12) der Zwischeneinheit (11) geometrisch zugeordnet ist.

2. Vorrichtung nach Anspruch 1,
**dadurch gekennzeichnet,**
**daß** Segmente (12) und Kontaktierungseinheiten (1) geometrisch auf ein einheitliches Rastermaß bezogen sind.

3. Vorrichtung nach Anspruch 1,
**dadurch gekennzeichnet,**
**daß** die Kontaktierungseinheit (1) eine Halterung (3), elektrisch leitfähige Kontaktierungsmittel (2) und elektrische Anschlußmittel (4) für eine Auswerteeinheit (10) oder für eine zwischen Auswerteeinheit (10) und Kontaktierungseinheit (1) zwischengeschaltete Zwischeneinheit (11) aufweist.

4. Vorrichtung nach Anspruch 1,
**dadurch gekennzeichnet,**
**daß** die Kontaktierungsmittel (2) der Kontaktierungseinheit (1) von zu kontaktierenden Spannungsquelleneinheiten (6) lösbare elektrische Federkontakte aufweisen.

5. Vorrichtung nach Anspruch 1,
**dadurch gekennzeichnet,**
**daß** die Kontaktierungseinheit (1) in Richtung ihrer Längsachse (5) verschiebbar in dem Haltermodul (8) angeordnet ist.

6. Vorrichtung nach Anspruch 1,
**dadurch gekennzeichnet,**
**daß** die Kontaktierungseinheit (1) senkrecht in eine Führungsschiene (9) des Haltermoduls (8) hineinragt, derart, daß die Kontaktierungseinheit (1) entlang der Führungsschiene (9) parallel zur Längsausdehnung des Gehäuses (13) oder zu einer Stapelrichtung der Spannungsquelleneinheiten (6) verschiebbar ist.

7. Vorrichtung nach Anspruch 1,
**dadurch gekennzeichnet,**
**daß** die Auswerteeinheit (10) ein zentrales Steuergerät ist.

8. Vorrichtung nach Anspruch 1,
**dadurch gekennzeichnet,**
**daß** die Auswerteeinheit (10) eine Einheit zur Adressierung und/oder Aufbereitung von Meßdaten aufweist.

9. Vorrichtung nach Anspruch 1,
**dadurch gekennzeichnet,**
**daß** die Kontaktierungseinheit (1) jeweils mit einer Flachbandleitung (14) elektrisch mit der Auswerteeinheit (10) oder der Zwischeneinheit (11) zumindest mittelbar verbunden ist.

10. Vorrichtung nach Anspruch 1,
**dadurch gekennzeichnet,**
**daß** die Zwischeneinheit (11) zusätzlich zu Segmenten (12) eine Grundeinheit (15) aufweist, welche zumindest eine Datenbusschnittstelle und/oder eine Microcontrollerkarte aufweist.

11. Vorrichtung nach Anspruch 1,
**dadurch gekennzeichnet,**
**daß** das Segment (12) Multiplexereinheiten und dem Segment (12) zugeordnete elektrische Verbindungsmittel (4.1) aufweist, an welche Verbindungsmittel (4.1) eine oder mehrere Kontaktierungseinheiten (1) anschließbar sind.

12. Vorrichtung nach Anspruch 1,
**dadurch gekennzeichnet,**
**daß** Kontaktierungseinheiten (1) und/oder elektrische Verbindungsmittel (4.1) und/oder Bereiche der Mutliplexereinheiten (M) und/oder Segmente (12) mit Multiplexereinheiten (M) und Verbindungsmitteln (4.1) äquidistant entlang der Längsachse der Zwischeneinheit (11) angeordnet sind.

13. Vorrichtung nach Anspruch 11 oder 12,
**dadurch gekennzeichnet,**
**daß** die Längsausdehnung zumindest von Segmenten (12), Verbindungsmitteln (4.1) und Kontaktierungseinheiten (1) entlang der Längsachse der Zwischeneinheit (11) gestaffelt ist, wobei die Längsausdehnung der Kontaktierungseinheiten (1) eine erste Länge (L1) ist, die Längsausdehnung der Bereiche von Multiplexereinheiten (M) eine zweite Länge (LM), die Längsausdehnung der Verbindungsmittel (4.1) eine dritte Länge (L4), die Längsausdehnung der Segmente (12) eine vierte Länge (L12) ist und wobei gilt, daß L1>L12>L4>LM.

14. Vorrichtung nach Anspruch 11, 12 oder 13,
**dadurch gekennzeichnet,**
**daß** die Längsausdehnung zumindest von Segmenten (12), Verbindungsmitteln (4.1) und Kontaktierungseinheiten (1) entlang der Längsachse der Zwischeneinheit (11) gestaffelt und versetzt zur Stapelrichtung der Spannungsquelleneinheiten (6) angeordnet ist, so daß beim Kürzen auf eine aktuelle Stapellänge der Spannungsquelleneinheiten (6) die Funktion von Segmenten (12), Verbindungsmitteln (4.1) und Kontaktierungseinheiten (1) erhalten ist

15. Vorrichtung nach Anspruch 1,
**dadurch gekennzeichnet,**
**daß** das Haltermodul (8) am Gehäuse (13) befestigbar ist.

16. Vorrichtung nach Anspruch 1,
**dadurch gekennzeichnet,**
**daß** das Haltermodul (8) an den Spannungsquelleneinheiten (6) befestigbar ist.

17. Vorrichtung nach Anspruch 1,
**dadurch gekennzeichnet,**
**daß** Befestigungsmittel der Zwischeneinheit (11) im Gehäuse (13) mit Mitteln zur Kompensation von Längenänderungen der Zwischeneinheit (11) und/oder des Gehäuses (13) versehen sind.

18. Vorrichtung nach Anspruch 1,
**dadurch gekennzeichnet,**
**daß** die Kontaktierungseinheit (1) mit einem Entlademodul verbunden ist, durch welches mindestens eine Spannungsquelleneinheit (6) entladbar ist.

19. Vorrichtung nach Anspruch 18,
**dadurch gekennzeichnet,**
**daß** das Entlademodul mit Mitteln zum Anschluß einer elektronischen Datenverarbeitungseinrichtung versehen ist.

20. Vorrichtung nach Anspruch 1,
**dadurch gekennzeichnet,**
**daß** die Spannungsquelleneinheit (6) eine Brennstoffzelle ist.

## Claims

1. Device for measuring the voltage at more than two voltage source units (6) of the same type, having contacting means (2) to measure the voltage and an evaluation unit (10) connected to the contacting means, such that at least several contacting means (2) are structurally assembled together in one contacting unit (1),
**characterised in that**
several contacting units (1) are arranged next to one another in the direction of their longitudinal axis (5) in a holding module (8),
and an intermediate unit (11) is connected between the contacting units (1) and the evaluation unit (10) to address and/or to prepare measurement data, and
each contacting unit (1) is geometrically associated with a segment (12) of the intermediate unit (11).

2. Device according to Claim 1,
**characterised in that**
the segments (12) and contacting units (1) are geometrically related by a uniform grid dimension.

3. Device according to Claim 1,
**characterised in that**
the contacting unit (1) comprises a holder (3), electrically conducting contacting means (2) and electric connection means (4) for an evaluation unit (10) or for an intermediate unit (11) connected between the evaluation unit (10) and the contacting unit (1).

4. Device according to Claim 1,
**characterised in that**
the contacting means (2) of the contacting unit (1) comprise spring contacts that can be detached from the voltage source units (6) with which contact is to be made.

5. Device according to Claim 1,
**characterised in that**
the contacting unit (1) is arranged in the holding module (8) so that it can be displaced in the direction of its longitudinal axis (5).

6. Device according to Claim 1,
**characterised in that**
the contacting unit (1) projects perpendicularly into a guide rail (9) of the holding module (8) in such manner that the contacting unit (1) can be moved along the guide rail (9) parallel to the longitudinal extension of the housing (13) or to a stacking direction of the voltage source units (6).

7. Device according to Claim 1,
**characterised in that**
the evaluation unit (10) is a central control unit.

8. Device according to Claim 1,
**characterised in that**
the evaluation unit (10) comprises a unit for addressing and/or for preparing measurement data.

9. Device according to Claim 1,
**characterised in that**
in each case the contacting unit (1) is connected electrically by a flat-strip connector (14), at least indirectly, to the evaluation unit (10) or to the intermediate unit (11).

10. Device according to Claim 1,
**characterised in that**
in addition to segments (12) the intermediate unit (11) comprises a basic unit (15) comprising at least a data bus interface and/or a micro-controller card.

11. Device according to Claim 1,
**characterised in that**
the segment (12) comprises multiplexer units and electrical connection means (4.1) associated with the segment (12), to which the connection means (4.1) of one or more contacting units (1) can be connected.

12. Device according to Claim 1,
**characterised in that**
contacting units (1) and/or electrical connection means (4.1) and/or areas of the multiplexer units (M) and/or segments (12) with multiplexer units (m) and connection means (4.1) are arranged equidistantly along the longitudinal axis of the intermediate unit (11).

13. Device according to Claims 11 or 12,
**characterised in that**
the longitudinal extension at least of segments (12), connection means (4.1) and contacting units (1) along the longitudinal axis of the intermediate unit (11) is staggered, such that the longitudinal extension of the contacting units (1) is a first length (L1), that of the areas of multiplexer units is a second length (LM), that of the connection means (4.1) a third length (4), that of the segments (12) a fourth length (12), and L1 > L12 > L4 > LM.

14. Device according to Claims 11, 12 or 13,
**characterised in that**
the longitudinal extension at least of the segments (12), the connection means (4.1) and the contacting units (1) along the longitudinal axis of the intermediate unit (11) is arranged staggered and offset relative to the stacking direction of the voltage source units (6), such that on shortening to an actual stacking length of the voltage source units (6), the function of the segments (12), connection means (4.1) and contacting units (1) is maintained.

15. Device according to Claim 1,
**characterised in that**
the holding module (8) can be attached to the housing (13).

16. Device according to Claim 1,
**characterised in that**
the holding module (8) can be attached to the voltage source units (6).

17. Device according to Claim 1,
**characterised in that**
means are provided for fixing the intermediate unit (11) in the housing (13), with means for compensating length changes of the intermediate unit (11) and/or those of the housing (13).

18. Device according to Claim 1,
**characterised in that**
the contacting unit (1) is connected to a discharge module, by means of which at least one voltage source unit (6) can be discharged.

19. Device according to Claim 18,
**characterised in that**
the discharge module is provided with means for the connection of an electronic data processing device.

20. Device according to Claim 1,
**characterised in that**
the voltage source unit (6) is a fuel cell.

## Revendications

1. Dispositif de mesure de tension sur plus de deux unités de source de tension identiques (6) équipé de moyens de mise en contact (2) en vue du prélèvement de tension et d'une unité d'évaluation (10) reliée aux moyens de mise en contact, au moins plusieurs moyens de mise en contact (2) étant réunis structuralement en une unité de mise en contact (1), **caractérisé en ce que** plusieurs unités de mise en contact (1) sont juxtaposées selon leur axe longitudinal (5) dans un module support (8), **en ce qu'**entre l'unité de mise en contact (1) et l'unité d'évaluation (10) est intercalée une unité intermédiaire (11) en vue de l'adressage et/ou le traitement de données de mesure et **en ce qu'**à chaque unité de mise en contact (1) est associé géométriquement un segment (12) de l'unité intermédiaire (11).

2. Dispositif selon la revendication 1, **caractérisé en ce que** des segments (12) et des unités de mise en contact (1) sont rapportés géométriquement à un module uniforme.

3. Dispositif selon la revendication 1, **caractérisé en ce que** l'unité de mise en contact (1) présente un support (3), des moyens de mise en contact (2) électriquement conducteurs et des moyens de raccordement électrique (4) pour une unité d'évaluation (10) ou pour une unité intermédiaire (11) intercalée entre l'unité d'évaluation (10) et l'unité de mise en contact (1).

4. Dispositif selon la revendication 1, **caractérisé en ce que** les moyens de mise en contact (2) de l'unité de mise en contact (1) présentent des contacts élastiques électriques amovibles d'unités de source de tension (6) à mettre en contact.

5. Dispositif selon la revendication 1, **caractérisé en ce que** l'unité de mise en contact (1) est disposée déplaçable dans le sens de son axe longitudinal (5) dans le module support (8).

6. Dispositif selon la revendication 1, **caractérisé en ce que** l'unité de mise en contact (1) pénètre perpendiculairement dans un rail de guidage (9) du module support (8), de telle sorte que l'unité de mise en contact (1) soit déplaçable le long du rail de guidage (9) parallèlement à l'étendue longitudinale du boîtier (13) ou à une direction d'empilage des unités de source de tension (6).

7. Dispositif selon la revendication 1, **caractérisé en ce que** l'unité d'évaluation (10) est un appareil de commande central.

8. Dispositif selon la revendication 1, **caractérisé en ce que** l'unité d'évaluation (10) comporte une unité en vue de l'adressage et/ou du traitement de données de mesure.

9. Dispositif selon la revendication 1, **caractérisé en ce que** l'unité de mise de contact (1) est reliée électriquement avec un conducteur en ruban plat (14) au moins par l'intermédiaire de l'unité d'évaluation (10) ou de l'unité intermédiaire(11).

10. Dispositif selon la revendication 1, **caractérisé en ce que** l'unité intermédiaire (11) présente en plus des segments (12) une unité fondamentale (15), qui présente au moins un point de coupure de bus de données et/ou une carte de microcontrôleur.

11. Dispositif selon la revendication 1, **caractérisé en ce que** le segment (12) présente des unités de multiplexage et des moyens de liaison (4.1) électrique associés au segment (12), auxquels moyens de liaison (4.1) peuvent être raccordées une ou plusieurs unités de mise en contact (1).

12. Dispositif selon la revendication 1, **caractérisé en ce que** les unités de mise en contact (1) et/ou les moyens de liaison électrique (4.1) et/ou des régions des unités de multiplexage (M) et/ou des segments (12) sont disposés équidistants avec les unités de multiplexage (M) et les moyens de liaison (4.1) le long de l'axe longitudinal de l'unité intermédiaire (11).

13. Dispositif selon la revendication 11 ou 12, **caractérisé en ce que** l'étendue longitudinale au moins des segments (12), des moyens de liaison (4.1) et des unités de mise en contact (1) est échelonnée le long de l'axe longitudinal de l'unité intermédiaire (11), l'étendue longitudinale des unités de mise en contact (1) est une première longueur (L1), l'étendue longitudinale des zones d'unités de multiplexage (M) une deuxième longueur (LM), l'étendue longitudinale des moyens de liaison (4.1) une troisième longueur (L4), l'étendue longitudinale des segments (12) une quatrième longueur (L12), et **en ce que** L1 > L12 > L4 > LM.

14. Dispositif selon la revendication 11, 12 ou 13, **caractérisé en ce que** l'étendue longitudinale au moins des segments (12), des moyens de liaison (4.1) et des unités de mise en contact (1) est échelonnée le long de l'axe longitudinal de l'unité intermédiaire (11) et est disposée décalée dans la direction de l'empilage des unités de source de tension (6), de sorte que lors d'un raccourcissement d'une longueur réelle d'empilage des unités de source de tension (6), la fonction des segments (12), des moyens de liaison (4.1) et des unités de mise en contact (1) est maintenue.

15. Dispositif selon la revendication 1, **caractérisé en ce que** le module support (8) peut être fixé au boîtier (13).

16. Dispositif selon la revendication 1, **caractérisé en ce que** le module support (8) peut être fixé aux unités de source de tension (6).

17. Dispositif selon la revendication 1, **caractérisé en ce que** les moyens de fixation de l'unité intermédiaire (11) dans le boîtier (13) sont munis de moyens de compensation de variations de longueur de l'unité intermédiaire (11) et/ou du boîtier (13).

18. Dispositif selon la revendication 1, **caractérisé en ce que** l'unité de mise en contact (1) est reliée à un module de décharge, par lequel au moins une unité de source de tension (6) peut être déchargée.

19. Dispositif selon la revendication 18, **caractérisé en ce que** le module de décharge est muni de moyens en vue du raccordement à un dispositif électronique de traitement de données.

20. Dispositif selon la revendication 1, **caractérisé en ce que** l'unité de source de tension (6) est une pile à combustible.
